(19) Europäisches Patentamt
European Patent Office
Office européen des brevets

(11) **EP 3 879 285 B1**

(12) **EUROPEAN PATENT SPECIFICATION**

(45) Date of publication and mention of the grant of the patent:
**28.09.2022 Bulletin 2022/39**

(21) Application number: **18939932.2**

(22) Date of filing: **13.11.2018**

(51) International Patent Classification (IPC):
**G01R 27/02** *(2006.01)*     **G01R 31/14** *(2006.01)*
**G01R 31/00** *(2006.01)*     **G01R 31/42** *(2006.01)*

(52) Cooperative Patent Classification (CPC):
**G01R 31/007; G01R 27/025; G01R 31/14; G01R 31/42**

(86) International application number:
**PCT/CN2018/115259**

(87) International publication number:
**WO 2020/097797 (22.05.2020 Gazette 2020/21)**

(54) **INSULATION DETECTION CIRCUIT OF VEHICLE-MOUNTED BIDIRECTIONAL CHARGER AND DETECTION METHOD THEREFOR**

ISOLATIONSERKENNUNGSSCHALTUNG EINES FAHRZEUGMONTIERTEN BIDIREKTIONALEN LADEGERÄTS UND DETEKTIONSVERFAHREN DAFÜR

CIRCUIT DE DÉTECTION D'ISOLATION DE CHARGEUR BIDIRECTIONNEL MONTÉ SUR VÉHICULE ET PROCÉDÉ DE DÉTECTION ASSOCIÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.09.2021 Bulletin 2021/37**

(73) Proprietor: **Shenzhen VMAX New Energy Co.,Ltd.**
**Shenzhen, Guangdong 518000 (CN)**

(72) Inventors:
• **LIU, Jun**
**Shenzhen, Guangdong 518000 (CN)**
• **FENG, Yingying**
**Shenzhen, Guangdong 518000 (CN)**

• **XU, Jinzhu**
**Shenzhen, Guangdong 518000 (CN)**
• **ZHANG, Yuanzhao**
**Shenzhen, Guangdong 518000 (CN)**

(74) Representative: **Sun, Yiming**
**HUASUN Patent- und Rechtsanwälte**
**Friedrichstraße 33**
**80801 München (DE)**

(56) References cited:
| | |
|---|---|
| WO-A1-2017/119125 | CN-A- 103 219 707 |
| CN-A- 107 748 292 | CN-B- 103 219 707 |
| CN-C- 100 498 358 | CN-U- 202 330 646 |
| CN-U- 203 658 468 | CN-U- 206 583 996 |
| US-A1- 2012 126 839 | US-B2- 9 696 384 |

**Description**

**TECHNICAL FIELD**

The present invention relates to charging equipment, and more particularly, to an insulation detection circuit and a detection method thereof for a two-way on-board charger.

**BACKGROUND**

CN 103 219 707 B describes a leakage protection circuit of a vehicle-mounted inverter and the corresponding vehicle-mounted inverter. The leakage protection circuit comprises an insulation resistance detecting circuit, a comparison circuit, and an output time-delay circuit. The insulation resistance detecting circuit is connected with the alternating current output end of the vehicle-mounted inverter to detect resistance to ground of the alternating current output end, and outputs a detected insulation resistance signal to the comparison circuit. When the insulation resistance is smaller than a preset threshold value, the comparison circuit outputs a defective insulation signal to the output time-delay circuit. When duration time of the defective insulation signal exceeds a preset time, the output time-delay circuit outputs a leakage protection signal to a microcontroller in order to stop outputting alternating current voltage. The leakage protection circuit detects the insulation resistance to ground of the alternating current output end, and outputs the leakage protection signal to a boost microcontroller and an inversion microcontroller to stop outputting alternating current voltage when the insulation resistance to ground is smaller than the preset value.

WO 2017/119125 A1 describes an insulation resistance measurement device comprising a voltage measurement unit for measuring the voltages of each phase of an AC power supply in relation to a ground, a current measurement unit for measuring the overall current of all phases on the secondary side of a power conversion device using a zero-phase current transformer, and an insulation resistance calculation unit for calculating the insulation resistance in relation to the ground on the secondary side of the power conversion device from the measured voltages and current. The insulation resistance is calculated on the basis of an equivalent circuit model of a load-side circuit with, as an AC power supply, a secondary-side fundamental voltage having the fundamental frequency after the rectification of the voltages.

US 9 696 384 B2 describes a system and method of simultaneously calculating an isolation resistance and a y-capacitance of a rechargeable energy storage system. The method may include the steps of: injecting a first signal into a rechargeable energy storage system; recording an output signal from the rechargeable energy storage system in response to the injection of the first signal; multiplying the first signal with the output signal to determine a first product; multiplying a second signal with the output signal to determine a second product, wherein the second signal is orthogonal to the first signal; filtering the first product to determine a first constant; filtering the second product to determine a second constant; processing the first constant to determine a y-capacitance value; and processing the second constant to determine an isolation resistance value.

CN 100 498 358 C describes an insulation monitoring method for a small current grounding system and a device for implementing the method, adopting a set of non-inductive element groups connected to the system by star connection and the neutral point being directly grounded, and measuring the non-inductive elements through a measuring device. The current or voltage parameters of said group provide the current or voltage information of the system relative to the ground. When the current measurement method is adopted, the current value is converted into a voltage value through a current/voltage converter, and the three-phase voltage of the system is displayed by a voltage display. Monitor insulation state of the system; use grounding alarm device to connect to the neutral line of non-inductive element group, measure the zero-sequence current of non-inductive element group, and display the insulation state of the system by alarm, thereby realizing a low-current grounding system insulation monitoring.

The energy crisis and environmental pollution have become increasingly serious worldwide, so the entire traditional automobile industry and the world's objective environment are facing severe challenges. With the strengthening of public environmental awareness, advocating green travel and changing the travel structure have become mainstream. With the plans of governments in developed countries to develop new energy vehicles, the Chinese government has also announced corresponding new energy vehicle development plans, and new energy vehicles have also been included in seven major emerging strategic industries. The new energy vehicles are currently the most mainstream of electric vehicles. An on-board charger is a very important component in an electric vehicle. The quality of the on-board charger directly affects the safety and reliability of the vehicle. The insulation quality between a live line and a ground line of the on-board charger is in turn related to the performances of the whole vehicle. For example, the failure of the insulation between the live line and the ground line can easily cause damage to components and even electric shock. The previous detection means is to use instruments to detect after a power failure, which is not only tedious to operate, but also cannot be monitored in real time.

Therefore, there is an urgent need in the industry to develop an insulation detection circuit and a detection method thereof that are simple to operate and can detect insulation in real time in an inverting mode.

## SUMMARY

In order to solve the problems existing in the prior art, the present invention provides an insulation detection circuit and a detection method thereof for a two-way on-board charger, which are used for detecting whether there is an insulation failure between an AC output and a vehicle body when the on-board charger operates in a pure inverting mode.

The technical solution adopted by the present invention is set out in the appended set of claims.

According to the present invention, when the on-board charger operates in an inverting mode, the insulation impedance of the output live line L and the output neutral line N to the ground is detected, and whether there is insulation failure between the AC output in the pure inversion mode and the vehicle body is determined, thereby eliminating the hidden danger of electric shock to personnel. Meanwhile, the present invention has the advantages of simple and practical structure, easy implementation and low cost.

## BRIEF DESCRIPTION OF THE DRAWINGS

FIG. 1 is a principle block diagram of a preferred embodiment of the present invention;

FIG. 2 is a circuit diagram without a summing circuit;

FIG. 3 is a circuit diagram with a summing circuit;

FIG. 4 is a waveform diagram of a summed voltage when the insulation is normal;

FIG. 5 is a waveform diagram of a summed voltage when the insulation fails;

FIG. 6 is a waveform diagram of a voltage at each point when the insulation is normal; and

FIG. 7 is a waveform diagram of a voltage at each point when the insulation fails.

## DETAILED DESCRIPTION

In order to make the objectives, technical solutions, and advantages of the present invention clearer, the present invention is further described in detail below with reference to the accompanying drawings and embodiments. It should be understood that the specific embodiments described herein are only used to explain the present invention and are not used to limit the present invention.

When the on-board charger operates in an inverting state, due to the requirements of a forward on-board charger (OBC) on the electromagnetic interference (EMI), there is a Y capacitor on each of the output live line L and the output neutral line N on an AC output port to the ground line during the inversion, and Y capacitance values of the output live line and the output neutral line to the ground are equal. In the presence of the Y capacitors, the output live line L and the output neutral line N generate a voltage to the ground, respectively, and the phases of the two voltages are staggered by 180 degrees. The amplitudes of the voltages are related to a ratio of the capacitance values of the output live line L and the output neutral line N of the capacitor. When the insulation of the output live line L or the output neutral line N to the ground fails, the voltage of the output live line L or the output neutral line N to the ground will lose balance.

The present invention discloses an insulation detection circuit and a detection method thereof for a two-way on-board charger. According to this method, in an inversion mode, the insulation impedances of the output live line L and the output neutral line N to the ground are obtained by detecting the voltages of the output live line L and the output neutral line N to the ground. Whether there is an insulation failure between AC output and the vehicle body when the on-board charger operates in a pure inversion mode is detected by using the insulation impedance, thereby eliminating the hidden danger of electric shock to personnel.

The insulation detection circuit for the two-way on-board charger disclosed by the present invention comprises an inverter circuit, a first Y capacitor C1 connected between an output live line and a ground line of the inverter circuit, a second Y capacitor C2 connected between an output neutral line and the ground line of the inverter circuit, a live line sampling circuit and a neutral line sampling circuit which are correspondingly connected with the output live line and the output neutral line of the inverter circuit, and a controller connected with the live line sampling circuit and the neutral line sampling circuit. The live line sampling circuit and the neutral line sampling circuit output a sampling voltage, respectively. The controller determines an insulation state of the two-way on-board charger according to the two sampling voltages.

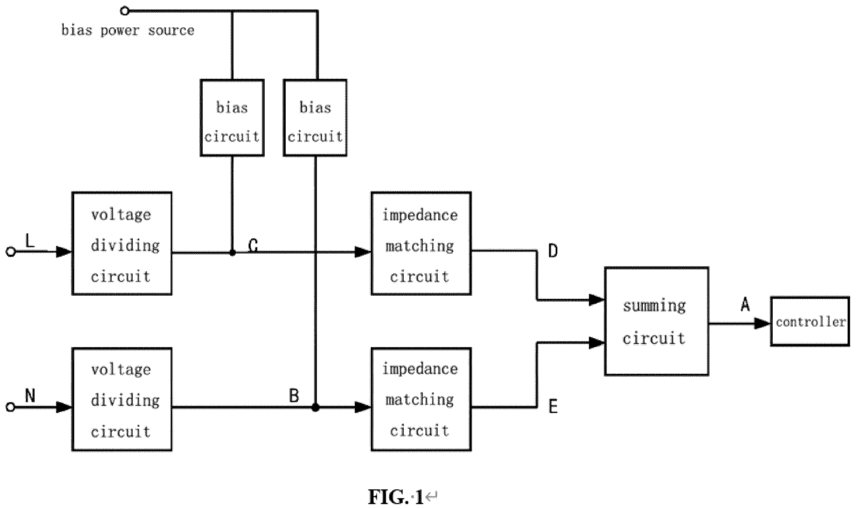

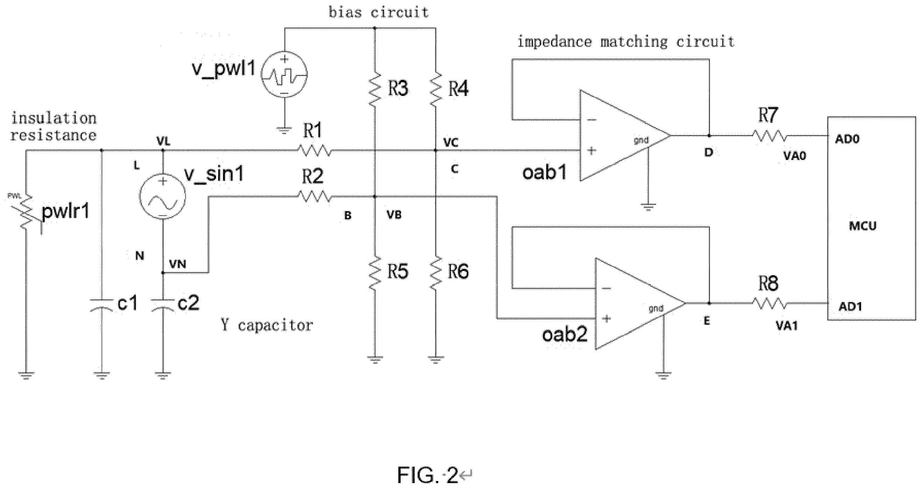

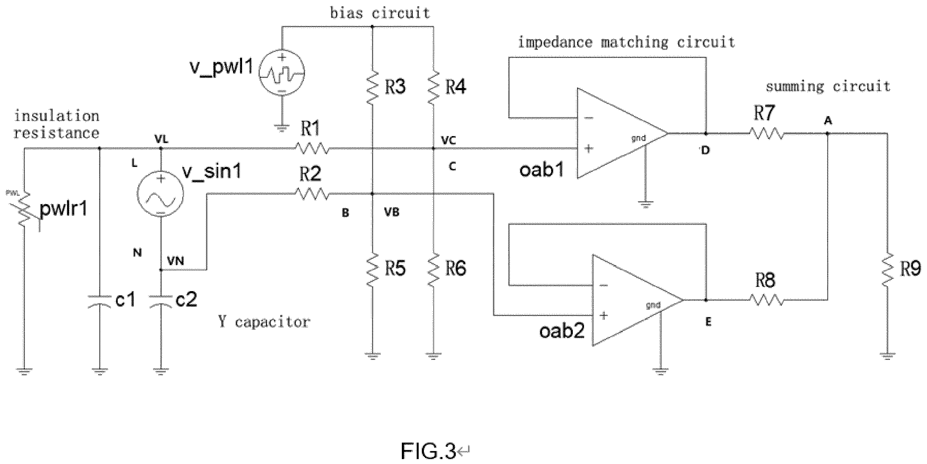

FIG. 1 is a principle block diagram of a preferred embodiment. A summing circuit is provided among the controller, the live line sampling circuit and the neutral line sampling circuit. The summing circuit is configured to perform summing processing on the two sampling voltages to obtain the summed voltage, and transmit the summed voltage to the controller. The controller determines an insulation state of the two-way on-board charger according to the summed voltage. It should be noted that the summing processing can be calculated inside the controller, and a circuit diagram of its embodiment is shown in FIG. 2. The summing processing may also be performed outside the controller. After the processing is completed, the summed voltage is transmitted to the controller, and a circuit diagram of its embodiment is shown in FIG. 3.

In the above embodiments, the live line sampling circuit and the neutral line sampling circuit have the same circuit structure, and each comprises a voltage dividing circuit, a bias power source, a negative bias circuit, and an impedance matching circuit. The voltage dividing circuit is connected with the output live line or the output neutral line, and configured to proportionally reduce voltages and output a divided voltage. The negative bias circuit is connected between an output terminal of the voltage dividing circuit and the bias power source and configured to bias the divided voltage. The impedance matching circuit is connected with the output terminal of the voltage dividing circuit, and configured to perform impedance matching and output a sampling voltage. It should be noted that the impedance matching circuit can match the impedances of an input terminal and an output terminal, so that the input impedance is high and the output impedance is low, thereby enhancing the load capacity.

Referring to the embodiments shown in FIG. 2 and FIG. 3, the voltage dividing circuit in the live line sampling circuit comprises a first resistor R1 and a sixth resistor R6 which are connected in series between the output live line and the ground line, and a connecting end G of the first resistor and the sixth resistor serves as the output terminal of the voltage dividing circuit. The voltage dividing circuit in the neutral line sampling circuit comprises a second resistor R2 and a fifth resistor R5 which are connected in series between the output neutral line and the ground line, and a connection end B of the second resistor and the fifth resistor serves as the output terminal of the voltage dividing circuit. A voltage division ratio is determined by a ratio of values of the first resistor R1 to the sixth resistor R6, and a ratio of values of the second resistor R2 to the fifth resistor R5. In this embodiment, R1=R2, R5=R6.

The negative bias circuit in the live line sampling circuit comprises a fourth resistor R4, wherein one end of the fourth resistor is connected with the bias power source, and the other end of the fourth resistor is connected with the connection end C of the first resistor and the sixth resistor. The negative bias circuit in the neutral line sampling circuit comprises a third resistor R3, wherein one end of the third resistor is connected with the bias power source, and the other end of the third resistor is connected with the connection end B of the second resistor and the fifth resistor. In this embodiment, R3=R4.

In this embodiment, the impedance matching circuit uses an emitter follower or a voltage follower.

The impedance matching circuit in the live line sampling circuit comprises a first operational amplifier oab1. A non-inverting input terminal of the first operational amplifier is connected with the connection end C of the first resistor and the sixth resistor. An output terminal of the first operational amplifier is connected with its inverting input terminal and outputs the sampling voltage. The impedance matching circuit in the neutral line sampling circuit comprises a second operational amplifier oab2. A non-inverting input terminal of the second operational amplifier is connected with the connection end B of the second resistor and the fifth resistor. An output terminal of the second operational amplifier is connected with its inverting input terminal and outputs the sampling voltage.

In this embodiment as shown in FIG. 3, the summing circuit comprises a seventh resistor R7, an eighth resistor R8, a ninth resistor R9, and an output terminal A. The seventh resistor R7 is connected in series between the output terminal A and the output terminal of the first operational amplifier. The eighth resistor R8 is connected in series between the output terminal A and the output terminal of the second operational amplifier. The ninth resistor R9 is connected in series between the output terminal A and the ground line. The output terminal A outputs the summed voltage to the controller.

The working principle of the present invention is described in detail below with reference to FIG. 3. There are Y capacitors for the output live line L and the output neutral line N of the converter circuit of the charger, that is, the first Y capacitor C1 and the second Y capacitor C2, where C1=C2. The Y capacitors causes the output live line L and the output neutral line N to generate voltages VL and VN to the ground, respectively. In addition, phases of these two voltages differ by 180 degrees. The amplitudes of these two voltages are related to the ratio of the Y capacitors, in which:

$$VL = Vac \cdot \sqrt{2} \cdot \sin(2 \cdot \pi \cdot f \cdot t + \pi) \cdot \frac{C1}{C1 + C2} \qquad \text{(Formula 1)}$$

$$VN = Vac \cdot \sqrt{2} \cdot \sin(2 \cdot \pi \cdot f \cdot t) \cdot \frac{C2}{C1 + C2} \qquad \text{(Formula 2)}$$

In the formulas, f is the frequency of an AC voltage, and t is a time.

The resistors R2 and R5 are connected between the output neutral line N and the ground line. The voltage on the output neutral line N is proportionally reduced. A voltage VB1 is formed at a point B of the connection end of R2 and R5. A resistor R3 is added between the bias power source v_pwl1 and the point B, and v_pwl1 and R3 and R5 form a DC bias voltage VB2 to a point C. The voltage VB at the point B is a sum of VB1 and VB2.

In which,

$$VB1 = VN*R5/(R2+R5) \qquad \text{(Formula 3)}$$

$$VB2 = v\_pwl1*R5/(R3+R5) \qquad \text{(Formula 4)}$$

$$VB = VB1+VB2 \qquad \text{(Formula 5)}$$

The resistors R1 and R6 are connected between the output live line L and the ground line. The voltage on the output live line L is proportionally reduced. A voltage VC1 is formed at the point C of the connection end of R1 and R6. A resistor R4 is added between the bias power source v_pwl1 and the point C, and v_pwl1 and R5 and R6 form a DC bias voltage VC2 to the point C. The voltage VC at the point C is a sum of VC1 and VC2.

$$VC1 = VL*R6/(R1+R6) \qquad \text{(Formula 6)}$$

$$VC2 = v\_pwl1*R6/(R4+R6) \qquad \text{(Formula 7)}$$

$$VC = VC1+VC2 \qquad \text{(Formula 8)}$$

After the voltage at the point C passes through the impedance matching circuit, the voltage VD at a point D of an output terminal D of the first operational amplifier is equal to VC. In the same way, after the voltage at the point B passes through the impedance matching circuit, the voltage VE at a point E of an output terminal E of the second operational amplifier is equal to VB. The voltages at the points D and E are added to the point A via the resistors R7 and R8. The voltage at the point A is:

$$VA = VD+VE \qquad \text{(Formula 9)}$$

VA is obtained in combination with Formulas 1 to 9.

$$VA =$$

$$\frac{(Vac \cdot \sqrt{2} \cdot \sin(2 \cdot \pi f \cdot t)) \cdot \left[\frac{-C1}{C1+C2} \cdot R5 \cdot (R1+R6) + \frac{C2}{C1+C2} \cdot R6 \cdot (R2+R5)\right]}{(R2+R5) \cdot (R1+R6)} + V\_PWL1 \cdot \frac{R6}{R4+R6} + V\_PWL1 \cdot \left(\frac{R5}{R3+R5}\right)$$

$$\text{(Formula 10)}$$

The voltage at the point A in Fig.2 and FIG. 3 is sent to an AD sampling port of the controller MCU. In a normal state, the impedances of the output live line L and the output neutral line N to the ground are infinite, that is, pwlr1 is infinite in FIG. 3. In addition, the value of the Y capacitor C1 of the output live line L to the ground is equal to the value of the Y capacitor C2 of the output neutral line N to the ground. In a normal insulation state, a divided voltage VB1 of the output live line L to the ground line and a divided voltage VC1 of the output neutral line N to the ground line add up to zero, which is as shown in the following formula;

$$VB1+VC1= \frac{(Vac \cdot \sqrt{2} \cdot \sin(2 \cdot \pi f \cdot t)) \cdot \left[ \frac{-C1}{C1 + C2} \cdot R5 \cdot (R1 + R6) + \frac{C2}{C1 + C2} \cdot R6 \cdot (R2 + R5) \right]}{(R2 + R5) \cdot (R1 + R6)}$$

A sum of the voltages at the point A is equal to a sum of negative bias voltages. That is, in the normal insulation state,

$$VA = V\_PWL1 \cdot \frac{R6}{R4 + R6} + V\_PWL1 \cdot \left( \frac{R5}{R3 + R5} \right)$$

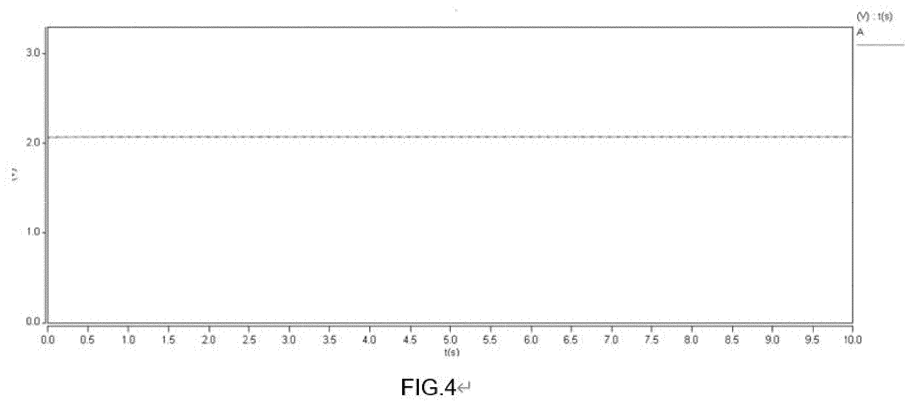

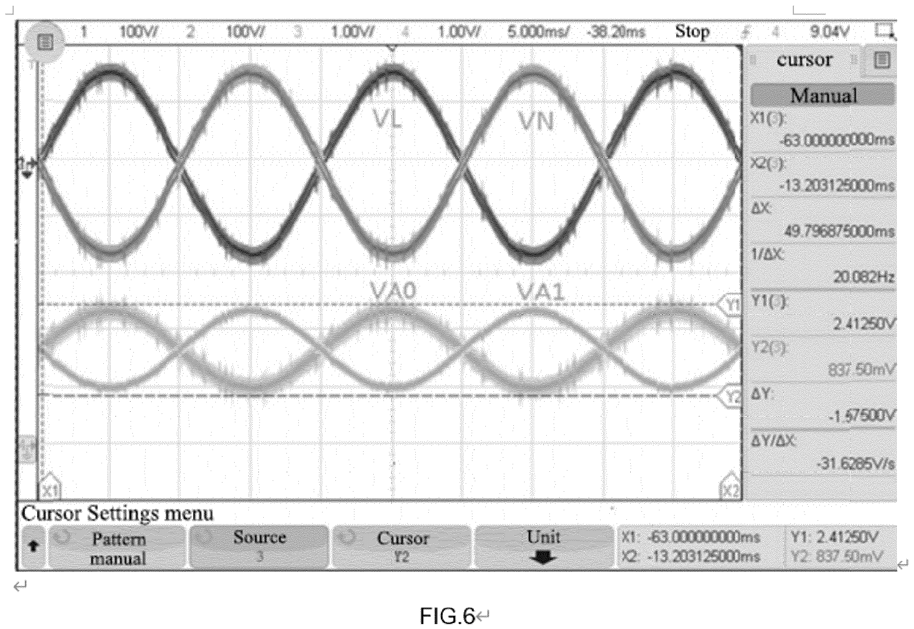

The controller MCU reads a voltage value at the point A through AD sampling. The voltage value at the point A is equal to a sum of negative bias voltage values of the output live line L and the output neutral line N (the voltage at the point A is shown in FIG. 4). The summed voltage remains constant in amplitude, and the graph shows a straight line. In this case, the controller MCU determines whether the output live line L and the output neutral line N are normally insulated. In the normal state, the insulation resistance pwlr1 is considered to be infinite, and the insulation resistance pwlr1 is ignored in the above formula. FIG. 6 shows voltage waveforms at various points when the insulation is normal. VL is a voltage of the output live line L to the ground, VN is a voltage of the output neutral line N to the ground, VA0 is a voltage at an output terminal of R7, and VA1 is a voltage at an output terminal of R8.

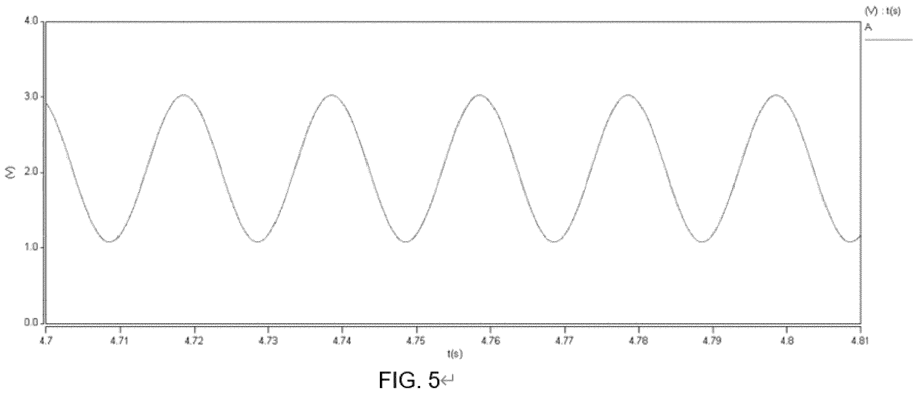

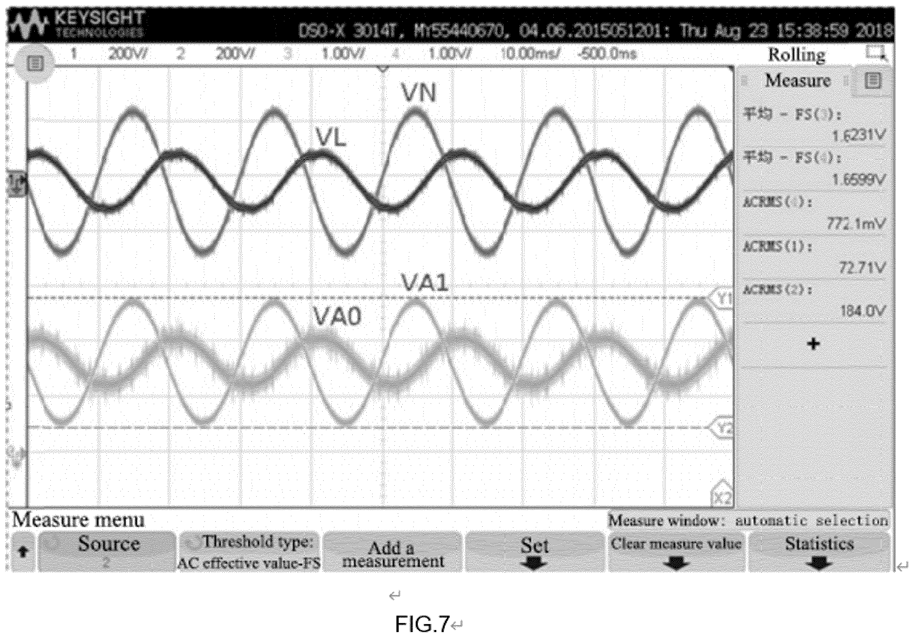

When the output live line L or the output neutral line N has an insulation failure to the ground line, the impedance of the output live line L or the output neutral line N to the ground line is decreasing. That is, PWLr1 in FIG. 2 or FIG. 3 decreases from infinity, and the impedance of the output live line L to the ground will decrease. In this case, the voltage of VL to the ground line and the voltage of VN to the ground line will lose balance, and the sum of VN and VL is no longer equal to zero. According to the actual measurement shown in FIG. 5, the amplitude of the summed voltage shows a sine wave waveform. The controller MCU will determine that the insulation fails according to the voltage value obtained by AD sampling, and meanwhile determine the amplitude of the value of the insulation resistance. FIG. 7 shows voltage waveforms at various points when the insulation fails. VL is a voltage of the output live line L to the ground, VN is a voltage of the output neutral line N to the ground, VA0 is a voltage at the output terminal of R7, and VA1 is a voltage at the output terminal of R8.

In an embodiment as shown in FIG. 2, the controller MCU uses two different AD sampling ports to input samplings of VL and VN to the MCU, and performs summing processing.

The present invention further discloses a detection method for an insulation detection circuit for a two-way on-board charger. The detection circuit comprises an inverter circuit, a first Y capacitor C1 connected between an output live line and a ground line of the inverter circuit, and a second Y capacitor C2 connected between an output neutral line and the ground line of the inverter circuit. The detection method comprises the following steps: sampling voltages on the output live line and the output neutral line of the inverter circuit, respectively; and determining an insulation state of the two-way on-board charger according to the two sampling voltages.

The detection method comprises the following steps: reducing voltages on the output live line and on the output neutral line of the inverter circuit proportionally by using a voltage dividing circuit respectively to generate a divided voltage; performing bias processing on the divided voltage by using a negative bias circuit, performing impedance matching on the divided voltage subjected to bias processing, and outputting a sampling voltage; performing summing processing on the sampling voltage of the output live line and the sampling voltage of the output neutral line by using a summing circuit to obtain a summed voltage; and determining an insulation state of the two-way on-board charger according to the summed voltage.

The above embodiments are merely examples, and are not limitative.

**Claims**

**1.** An insulation detection circuit for a two-way on-board charger, comprising an inverter circuit, and further comprising a live line sampling circuit and a neutral line sampling circuit correspondingly connected with an output live line (L) and an output neutral line (N) of the inverter circuit, and a controller (MCU) connected with the live line sampling circuit and the neutral line sampling circuit, wherein the controller determines an insulation state of the two-way on-board charger according to sampling voltages (VL, VN) respectively output by the two sampling circuits,

**characterized in that** said insulation detection circuit
further comprises a first Y capacitor (C1) connected between said output live line and a ground line of said inverter circuit, and a second Y capacitor (C2) connected between said output neutral line and said ground line of said inverter circuit,
wherein the live line sampling circuit and the neutral line sampling circuit have a same circuit structure, and each comprises a voltage dividing circuit (R1, R6 and R2, R5, respectively), a bias power source (v_pwl1), a bias circuit (R4 and R3, respectively), and an impedance matching circuit, wherein:

the voltage dividing circuit is connected with the output live line or the output neutral line, and configured to proportionally reduce voltages to output a divided voltage (VC, VB);
the bias circuit is connected between an output terminal (C, B) of the voltage dividing circuit and the bias power source and configured to bias the divided voltage; and
the impedance matching circuit is connected with the output terminal of the voltage dividing circuit, and configured to perform impedance matching and output a sampling voltage.

2. The insulation detection circuit for the two-way on-board charger according to claim 1, wherein a summing circuit (R7, R8, R9) is provided among the controller, the live line sampling circuit and the neutral line sampling circuit and configured to perform summing processing on the two sampling voltages and output a summed voltage; and the controller determines an insulation state of the two-way on-board charger according to the summed voltage.

3. The insulation detection circuit for the two-way on-board charger according to claim 1, wherein the voltage dividing circuit in the live line sampling circuit comprises a first resistor (R1) and a sixth resistor (R6) which are connected in series between the output live line and the ground line, and a connection end of the first resistor and the sixth resistor serves as the output terminal of the voltage dividing circuit; the voltage dividing circuit in the neutral line sampling circuit comprises a second resistor (R2) and a fifth resistor (R5) which are connected in series between the output neutral line and the ground line, and a connection end of the second resistor and the fifth resistor serves as the output terminal of the voltage dividing circuit.

4. The insulation detection circuit for the two-way on-board charger according to claim 3, wherein the bias circuit in the live line sampling circuit comprises a fourth resistor (R4), wherein one end of the fourth resistor is connected with the bias power source, and the other end of the fourth resistor is connected with the connection end of the first resistor and the sixth resistor; the bias circuit in the neutral line sampling circuit comprises a third resistor (R3), wherein one end of the third resistor is connected with the bias power source, and the other end of the third resistor is connected with the connection end of the second resistor and the fifth resistor.

5. The insulation detection circuit for the two-way on-board charger according to claim 4, wherein the impedance matching circuit uses an emitter follower or a voltage follower.

6. The insulation detection circuit for the two-way on-board charger according to claim 4, wherein the impedance matching circuit in the live line sampling circuit comprises a first operational amplifier, wherein a non-inverting input terminal (oab1) of the first operational amplifier is connected with the connection end of the first resistor and the sixth resistor, and an output terminal (D) of the first operational amplifier is connected with its inverting input terminal and outputs the sampling voltage; the impedance matching circuit in the neutral line sampling circuit comprises a second operational amplifier, wherein a non-inverting input terminal (oab2) of the second operational amplifier is connected with the connection end of the second resistor and the fifth resistor, and an output terminal (E) of the second operational amplifier is connected with its inverting input terminal and outputs the sampling voltage.

7. The insulation detection circuit for the two-way on-board charger according to claim 6, wherein the summing circuit comprises a seventh resistor (R7), an eighth resistor (R8), a ninth resistor (R9), and an output terminal A; the seventh resistor is connected in series between the output terminal A and an output terminal (D) of the first operational amplifier; an eighth resistor is connected in series between the output terminal A and an output terminal (E) of the second operational amplifier; the ninth resistor is connected in series between the output terminal A and the ground line; and the output terminal A outputs the summed voltage.

8. A detection method for an insulation detection circuit for a two-way on-board charger, the insulation detection circuit comprising an inverter circuit, wherein the detection method comprising: sampling voltages on an output live line (L) and an output neutral line (N) of the inverter circuit, respectively; and determining an insulation state of the two-way on-board charger by a controller (MCU) according to two sampling voltages,

> **characterized in that**
> said insulation detection circuit further comprises a first Y capacitor (C1) connected between said output live line and a ground line of said inverter circuit, and a second Y capacitor (C2) connected between said output neutral line and said ground line of said inverter circuit;
> wherein the detection method specifically comprises the following steps:
>
> > reducing voltages on the output live line and on the output neutral line of the inverter circuit proportionally by using a voltage dividing circuit respectively to generate a divided voltage;
> > performing bias processing on the divided voltage by using a bias circuit;
> > performing impedance matching on the divided voltage subjected to bias processing; and
> > outputting said sampling voltages;
> > performing summing processing on the sampling voltage of the output live line and the sampling voltage of the output neutral line by using a summing circuit;
> > outputting the summed voltage; and
> > determining an insulation state of the two-way on-board charger according to the summed voltage.

**Patentansprüche**

1. Isolationserkennungsschaltung für ein Zweiwege-Bordladegerät, umfassend eine Wechselrichterschaltung und ferner umfassend eine Abtastschaltung für eine stromführende Leitung und eine Abtastschaltung für eine Nullleitung, die entsprechend mit einer Ausgangsstromleitung (L) und mit einer Ausgangsnullleitung (N) der Wechselrichterschaltung verbunden sind, und eine Steuerung (MCU), die mit der Abtastschaltung der stromführenden Leitung und mit der Abtastschaltung der Nullleitung verbunden ist, wobei die Steuerung einen Isolationszustand des Zweiwege-Bordladegeräts gemäß Abtastspannungen (VL, VN), die jeweils von den beiden Abtastschaltungen ausgegeben werden, bestimmt,

> **dadurch gekennzeichnet, dass** die Isolationserfassungsschaltung ferner einen ersten Y-Kondensator (C1), der zwischen der stromführenden Ausgangsleitung und einer Masseleitung der Wechselrichterschaltung angeschlossen ist, und einen zweiten Y-Kondensator (C2) umfasst, der zwischen der Ausgangsnullleitung und der Masseleitung der Wechselrichterschaltung angeschlossen ist,
> wobei die Abtastschaltung für die stromführende Leitung und die Abtastschaltung für die Nullleitung dieselbe Schaltungsstruktur aufweisen und jede eine Spannungsteilerschaltung (R1, R6 beziehungsweise R2, R5), eine Vorspannungsquelle (v_pwl1), eine Vorspannungsschaltung (R4 beziehungsweise R3) und eine Impedanzanpassungsschaltung umfasst, wobei:
>
> > die Spannungsteilerschaltung mit der stromführenden Ausgangsleitung oder der Ausgangsnullleitung verbunden ist und so konfiguriert ist, um Spannungen proportional zu reduzieren, um eine geteilte Spannung (VC, VB) auszugeben;
> > die Vorspannungsschaltung zwischen einem Ausgangsanschluss (C, B) der Spannungsteilerschaltung und der Vorspannungsquelle der Spannungsteilerschaltung angeschlossen ist und so konfiguriert ist, die geteilte Spannung vorzuspannen; und
> > die Impedanzanpassungsschaltung mit dem Ausgangsanschluss der Spannungsteilerschaltung verbunden ist und so konfiguriert ist, dass sie eine Impedanzanpassung durchführt und eine Abtastspannung ausgibt.

2. Isolationserkennungsschaltung für das Zweiwege-Bordladegerät nach Anspruch 1, wobei eine Summierschaltung (R7, R8, R9) zwischen der Steuerung, der Abtastschaltung für die stromführende Leitung und der Abtastschaltung für die Nullleitung vorgesehen ist und zum Ausführen von Summierungsverarbeitung an den zwei Abtastspannungen und zur Ausgabe einer summierten Spannung konfiguriert ist; und wobei die Steuerung einen Isolationszustand des Zweiwege-Bordladegeräts gemäß der summierten Spannung bestimmt.

3. Isolationserkennungsschaltung für das Zweiwege-Bordladegerät nach Anspruch 1, wobei die Spannungsteilerschaltung in der Abtastschaltung für eine stromführende Leitung einen ersten Widerstand (R1) und einen sechsten Widerstand (R6) umfasst, die zwischen der stromführenden Ausgangsleitung und der Masseleitung in Reihe geschaltet sind, und wobei ein Verbindungsende des ersten Widerstands und des sechsten Widerstands als der Ausgangsanschluss der Spannungsteilerschaltung dient; wobei die Spannungsteilerschaltung in der Nullleiter-Abtastschaltung einen zweiten Widerstand (R2) und einen fünften Widerstand (R5) umfasst, die zwischen der Ausgangsnullleitung und der Masseleitung in Reihe geschaltet sind, und wobei ein Verbindungsende des zweiten Widerstands und des fünften Widerstands als Ausgangsanschluss der Spannungsteilerschaltung dient.

4. Isolationserkennungsschaltung für das Zweiwege-Bordladegerät nach Anspruch 3, wobei die Vorspannungsschaltung in der Abtastschaltung für eine stromführende Leitung einen vierten Widerstand (R4) umfasst, wobei ein Ende des vierten Widerstands mit der Vorspannungsquelle verbunden ist und das andere Ende des vierten Widerstands mit dem Verbindungsende des ersten Widerstands und des sechsten Widerstands verbunden ist; wobei die Vorspannungsschaltung in der Nullleiter-Abtastschaltung einen dritten Widerstand (R3) umfasst, wobei ein Ende des dritten Widerstands mit der Vorspannungsenergiequelle verbunden ist und das andere Ende des dritten Widerstands mit dem Verbindungsende des zweiten Widerstands und des fünften Widerstands verbunden ist.

5. Isolationserfassungsschaltung für das Zweiwege-Bordladegerät nach Anspruch 4, wobei die Impedanzanpassungsschaltung einen Emitterfolger oder einen Spannungsfolger verwendet.

6. Isolationserkennungsschaltung für das Zweiwege-Bordladegerät nach Anspruch 4, wobei die Impedanzanpassungsschaltung in der Abtastschaltung für eine stromführende Leitung einen ersten Operationsverstärker umfasst, wobei ein nicht invertierender Eingangsanschluss (oab1) des ersten Operationsverstärkers mit dem Verbindungsende des ersten Widerstands und des sechsten Widerstands verbunden ist, und ein Ausgangsanschluss (D) des ersten Operationsverstärkers mit seinem invertierenden Eingangsanschluss verbunden ist und die Abtastspannung ausgibt; wobei die Impedanzanpassungsschaltung in der Nullleiter-Abtastschaltung einen zweiten Operationsverstärker umfasst, wobei ein nicht invertierender Eingangsanschluss (oab2) des zweiten Operationsverstärkers mit dem Verbindungsende des zweiten Widerstands und des fünften Widerstands verbunden ist und ein Ausgangsanschluss (E) des zweiten Operationsverstärkers mit seinem invertierenden Eingangsanschluss verbunden ist und die Abtastspannung ausgibt.

7. Isolationserfassungsschaltung für das Zweiwege-Bordladegerät nach Anspruch 6, wobei die Summierschaltung einen siebten Widerstand (R7), einen achten Widerstand (R8), einen neunten Widerstand (R9) und einen Ausgangsanschluss A umfasst; wobei der siebente Widerstand zwischen dem Ausgangsanschluss A und einem Ausgangsanschluss (D) des ersten Operationsverstärkers in Reihe geschaltet ist; ein achter Widerstand zwischen dem Ausgangsanschluss A und einem Ausgangsanschluss (E) des zweiten Operationsverstärkers in Reihe geschaltet ist; der neunte Widerstand zwischen dem Ausgangsanschluss A und der Masseleitung in Reihe geschaltet ist; und der Ausgangsanschluss A die summierte Spannung ausgibt.

8. Erkennungsverfahren für eine Isolationserkennungsschaltung für ein Zweiwege-Bordladegerät, wobei die Isolationserkennungsschaltung eine Wechselrichterschaltung umfasst, wobei das Erkennungsverfahren umfasst: Abtasten von Spannungen auf einer stromführenden Ausgangsleitung (L) und auf einem Ausgangsnullleiter (N) der Wechselrichterschaltung; und Bestimmen eines Isolationszustands des Zweiwege-Bordladegeräts durch eine Steuerung (MCU) gemäß zweier Abtastspannungen,

**dadurch gekennzeichnet, dass**
die Isolationserfassungsschaltung ferner einen ersten Y-Kondensator (C1), der zwischen der spannungsführenden Ausgangsleitung und einer Masseleitung der Wechselrichterschaltung angeschlossen ist, und einen zweiten Y-Kondensator (C2) umfasst, der zwischen der Ausgangsnullleitung und der Masseleitung der Wechselrichterschaltung angeschlossen ist;
wobei das Erkennungsverfahren insbesondere die folgenden Schritte umfasst:

Reduzieren von Spannungen auf der stromführenden Ausgangsleitung und auf der Ausgangsnullleitung der Wechselrichterschaltung proportional jeweils unter Verwendung einer Spannungsteilerschaltung, um eine geteilte Spannung zu erzeugen;
Durchführen einer Vorspannungsverarbeitung an der geteilten Spannung unter Verwendung einer Vorspannungsschaltung;
Durchführen einer Impedanzanpassung an der geteilten Spannung, die einer Vorspannungsverarbeitung unterzogen wird; und
Ausgeben der Abtastspannungen;

Durchführen einer Summierungsverarbeitung an der Abtastspannung der stromführenden Ausgangsleitung und an der Abtastspannung der Ausgangsnullleitung unter Verwendung einer Summierschaltung;
Ausgeben der summierten Spannung; und
Bestimmen eines Isolationszustands des Zweiwege-Bordladegeräts gemäß der summierten Spannung.

**Revendications**

1.  Circuit de détection d'isolation pour un chargeur embarqué bidirectionnel, comprenant un circuit d'onduleur, et comprenant en outre un circuit d'échantillonnage de ligne sous tension et un circuit d'échantillonnage de ligne neutre connecté de manière correspondante à une ligne sous tension de sortie (L) et une ligne neutre de sortie (N) du circuit d'onduleur, et un contrôleur (MCU) connecté au circuit d'échantillonnage de ligne sous tension et au circuit d'échantillonnage de ligne neutre, dans lequel le contrôleur détermine un état d'isolation du chargeur embarqué bidirectionnel selon des tensions d'échantillonnage (VL, VN) délivrés respectivement par les deux circuits d'échantillonnage,
    **caractérisé en ce que** ledit circuit de détection d'isolation comprend en outre un premier condensateur (C1) connecté entre ladite ligne sous tension de sortie et une ligne de masse dudit circuit d'onduleur, et un deuxième condensateur (C2) connecté entre ladite ligne neutre de sortie et ladite ligne de masse dudit circuit d'onduleur, dans lequel le circuit d'échantillonnage de ligne sous tension et le circuit d'échantillonnage de ligne neutre ont une même structure de circuit, et chacun comprend un circuit diviseur de tension (R1, R6 et R2, R5, respectivement), une source d'alimentation de polarisation (v_pwl1), un circuit de polarisation (R4 et R3, respectivement), et un circuit d'adaptation d'impédance, dans lequel :

    le circuit de division de tension est connecté à la ligne sous tension de sortie ou à la ligne neutre de sortie, et configuré pour réduire proportionnellement les tensions pour produire une tension divisée (VC, VB) ;
    le circuit de polarisation est connecté entre une borne de sortie (C, B) du circuit de division de tension et la source d'alimentation de polarisation et configuré pour polariser la tension divisée ; et
    le circuit d'adaptation d'impédance est connecté à la borne de sortie du circuit de division de tension, et configuré pour effectuer l'adaptation d'impédance et délivrer en sortie une tension d'échantillonnage.

2.  Circuit de détection d'isolation pour le chargeur embarqué bidirectionnel selon la revendication 1, dans lequel un circuit de sommation (R7, R8, R9) est prévu entre le contrôleur, le circuit d'échantillonnage de ligne sous tension et le circuit d'échantillonnage de ligne neutre et configuré pour effectuer un traitement de sommation sur les deux tensions d'échantillonnage et sortir une tension sommée ; et le contrôleur détermine un état d'isolation du chargeur embarqué bidirectionnel en fonction de la tension sommée.

3.  Circuit de détection d'isolation pour le chargeur embarqué bidirectionnel selon la revendication 1, dans lequel le circuit diviseur de tension dans le circuit d'échantillonnage de ligne sous tension comprend une première résistance (R1) et une sixième résistance (R6) qui sont connectées en série entre la ligne sous tension de sortie et la ligne de masse, et une extrémité de connexion du la première résistance et la sixième résistance servent de borne de sortie du circuit diviseur de tension ; le circuit diviseur de tension dans le circuit d'échantillonnage de ligne neutre comprend une deuxième résistance (R2) et une cinquième résistance (R5) qui sont connectées en série entre la ligne neutre de sortie et la ligne de masse, et une extrémité de connexion de la deuxième résistance et de la cinquième résistance sert de borne de sortie du circuit diviseur de tension.

4.  Circuit de détection d'isolation pour le chargeur embarqué bidirectionnel selon la revendication 3, dans lequel le circuit de polarisation dans le circuit d'échantillonnage de ligne sous tension comprend une quatrième résistance (R4), dans lequel une extrémité de la quatrième résistance est connectée à la source d'alimentation de polarisation, et l'autre extrémité de la quatrième résistance est connectée à l'extrémité de connexion de la première résistance et de la sixième résistance ; le circuit de polarisation dans le circuit d'échantillonnage de ligne neutre comprend une troisième résistance (R3), dans laquelle une extrémité de la troisième résistance est connectée à la source d'alimentation de polarisation, et l'autre extrémité de la troisième résistance est connectée à l'extrémité de connexion de la deuxième résistance et la cinquième résistance.

5.  Circuit de détection d'isolation pour le chargeur embarqué bidirectionnel selon la revendication 4, **caractérisé en ce que** le circuit d'adaptation d'impédance utilise un émetteur suiveur ou un suiveur de tension.

6.  Circuit de détection d'isolation pour le chargeur embarqué bidirectionnel selon la revendication 4, dans lequel le circuit d'adaptation d'impédance dans le circuit d'échantillonnage de ligne sous tension comprend un premier amplificateur opérationnel, dans lequel une borne d'entrée non inverseuse (oab1) du premier amplificateur opérationnel est connectée à l'extrémité de connexion de la première résistance et de la sixième résistance, et une borne de sortie (D) du premier amplificateur opérationnel est connectée à sa borne d'entrée inverseuse et délivre la tension d'échantillonnage ; le circuit d'adaptation d'impédance dans le circuit d'échantillonnage de ligne neutre comprend un deuxième amplificateur opérationnel, dans lequel une borne d'entrée non inverseuse (oab2) du deuxième amplificateur opérationnel est connectée à l'extrémité de connexion de la deuxième résistance et la cinquième résistance, et une borne de sortie (E) du deuxième amplificateur opérationnel est connectée à sa borne d'entrée inverseuse et délivre la tension d'échantillonnage.

7. Circuit de détection d'isolation pour le chargeur embarqué bidirectionnel selon la revendication 6, dans lequel le circuit de sommation comprend une septième résistance (R7), une huitième résistance (R8), une neuvième résistance (R9) et une borne de sortie A ; la septième résistance est connectée en série entre la borne de sortie A et une borne de sortie (D) du premier amplificateur opérationnel ; une huitième résistance est connectée en série entre la borne de sortie A et une borne de sortie (E) du deuxième amplificateur opérationnel ; la neuvième résistance est connectée en série entre la borne de sortie A et la ligne de masse ; et la borne de sortie délivre la tension sommée.

8. Procédé de détection pour un circuit de détection d'isolation pour un chargeur embarqué bidirectionnel, le circuit de détection d'isolation comprenant un circuit d'onduleur, dans lequel le procédé de détection comprend : l'échantillonnage de tensions sur une ligne sous tension de sortie (L) et une ligne neutre de sortie (N) du circuit inverseur, respectivement ; et la détermination d'un état d'isolation du chargeur embarqué bidirectionnel par un contrôleur (MCU) en fonction de deux tensions d'échantillonnage,

   **caractérisé en ce que**
   ledit circuit de détection d'isolation comprend en outre un premier condensateur (C1) connecté entre ladite ligne sous tension de sortie et une ligne de masse dudit circuit inverseur, et un deuxième condensateur (C2) connecté entre ladite ligne neutre de sortie et ladite ligne de masse dudit circuit inverseur ;
   dans lequel le procédé de détection comprend spécifiquement les étapes suivantes consistant à :

   réduire proportionnellement les tensions sur la ligne sous tension de sortie et sur la ligne neutre de sortie du circuit inverseur en utilisant respectivement un circuit diviseur de tension pour générer une tension divisée ;
   effectuer un traitement de polarisation sur la tension divisée en utilisant un circuit de polarisation ;
   effectuer une adaptation d'impédance sur la tension divisée soumise au traitement de polarisation ; et délivrer lesdites tensions d'échantillonnage;
   effectuer un traitement de sommation sur la tension d'échantillonnage de la ligne sous tension de sortie et la tension d'échantillonnage de la ligne neutre de sortie en utilisant un circuit de sommation ;
   délivrer la tension sommée; et
   déterminer un état d'isolation du chargeur embarqué bidirectionnel en fonction de la tension sommée.

FIG. 1

FIG. 2

FIG.3

FIG.4

15

FIG. 5

FIG.6

FIG.7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 103219707 B
- WO 2017119125 A1
- US 9696384 B2
- CN 100498358 C